# EUROPÄISCHE PATENTANMELDUNG

(11) **EP 1 553 421 A2**
(43) Veröffentlichungstag der Anmeldung: **13.07.2005**
(21) Anmeldenummer: 05100146.9
(22) Anmeldetag: 12.01.2005
(51) Int. Cl.: G01R 29/22

(54) **Prüfverfahren und Prüfeinrichtung für einen Piezoaktor**

(30) Priorität: 12.01.2004 DE 102004001692
(71) Anmelder: Siemens Aktiengesellschaft, 80333 München (DE)
(72) Erfinder: Denzler, Michael, 93055, Regensburg (DE); Hägler, Christian, 92533, Wernberg-Köblitz (DE)

(57) **Zusammenfassung**

Die Erfindung betrifft ein Prüfverfahren für einen elektromechanischen Wandler, insbesondere zur Prüfung der Polungsrichtung eines Piezoaktors in einem Injektor für eine Einspritzanlage, mit den folgenden Schritten: Mechanische Belastung des Wandlers mit einem mechanischen Prüfsignal, Erfassung eines durch die mechanische Belastung erzeugten elektrischen Antwortsignals des Wandlers und Auswertung des Antwortsignals des Wandlers zur Prüfung des in das Bauteil eingebauten Wandlers. Weiterhin umfasst die Erfindung eine entsprechende Prüfeinrichtung.

## Beschreibung

Die Erfindung betrifft ein Prüfverfahren für einen elektromechanischen Wandler, insbesondere zur Prüfung der Polungsrichtung eines Piezoaktors in einem Injektor für eine Einspritzanlage, gemäß dem Oberbegriff des Anspruchs 1 sowie eine entsprechende Prüfeinrichtung gemäß dem Oberbegriff des Anspruchs 11.

In modernen Einspritzanlagen für Brennkraftmaschinen werden zunehmend Injektoren eingesetzt, die durch Piezoaktoren mechanisch angesteuert werden, da Piezoaktoren im Vergleich zu herkömmlichen elektromagnetischen Aktoren ein dynamischeres Stellverhalten ermöglichen. Die in derartigen Injektoren eingebauten Piezoaktoren weisen eine vorgegebene Polungsrichtung auf, die durch eine herstellerseitig durchgeführte Polarisierung festgelegt wird, wie beispielsweise in DE 100 28 335 A1 beschrieben ist. Bei der Lieferung derartiger Injektoren mit vorgepolten Piezoaktoren an Kraftfahrzeughersteller müssen diese darauf achten, dass die elektrische Ansteuerung des Piezoaktors entsprechend der vorgegebenen Polungsrichtung erfolgt, da der Injektor andernfalls nicht funktioniert und durch die fehlerhafte Ansteuerung irreversibel verändert und/oder beschädigt wird. Einige Rückläufer von vermeintlich fehlerhaften Injektoren mit derartigen Piezoaktoren beruhten deshalb nicht auf einem herstellerseitigen Fehler, sondern wurden dadurch verursacht, dass der Piezoaktor beim Kunden falsch angesteuert wurde. Zum Ausschluss von Gewährleistungsansprüchen wurden derartige Rückläufer von Injektoren mit fehlerhaften Piezoaktoren bisher aufwendigen Prüfungen unterzogen, wobei die Piezoaktoren entsprechend der herstellerseitig vorgegebenen Polungsrichtung elektrisch angesteuert werden. Derartige Prüfungen sind jedoch nicht aussagekräftig, wenn der fehlerhafte Piezoaktor zuvor vom Kunden falsch angesteuert wurde und dies zu einer Umpolung des Piezoaktors geführt hat.

Es ist deshalb zur Vermeidung aufwendiger herstellerseitiger Prüfungen von Injektoren mit vermeintlich fehlerhaften Piezoaktoren wünschenswert, ein Prüfverfahren zu entwickeln, das eine Ermittlung der Polungsrichtung eines Piezoaktors ermöglicht.

Eine derartige Ermittlung der Polungsrichtung eines in einem Injektor eingebauten Piezoaktors ist jedoch bisher nur nach einer Demontage des Injektors und des Piezoaktors möglich, was eine irreversible Veränderung des Injektors bedeutet und eine exakte Fehleranalyse an dem zusammengebauten Injektor ausschließt.

Der Erfindung liegt deshalb die Aufgabe zugrunde, ein Prüfverfahren und eine entsprechende Prüfeinrichtung zu schaffen, um an einem Injektor mit einem eingebauten Piezoaktor die Polungsrichtung des Piezoaktors zu ermitteln, ohne dass der Injektor zuvor demontiert werden muss.

Diese Aufgabe wird durch ein Prüfverfahren gemäß Anspruch 1 und eine entsprechende Prüfeinrichtung gemäß Anspruch 11 gelöst.

Die Erfindung umfasst die allgemeine technische Lehre, zur Prüfung eines Piezoaktors den piezoelektrischen Effekt des Piezoaktors auszunutzen, indem der Piezoaktor mit einem Prüfsignal mechanisch belastet wird, wobei ein elektrisches Antwortsignal des Piezoaktors ermittelt wird, dessen Auswertung eine Prüfung des Piezoaktors erlaubt.

Darüber hinaus umfasst die Erfindung auch die technische Lehre, den pyroelektrischen Effekt zur Prüfung des Piezoaktors auszunutzen. Darunter ist eine elektrische Reaktion des Piezoaktors auf eine Temperaturänderung zu verstehen. Der Piezoaktor kann deshalb im Rahmen des erfindungsgemäßen Prüfverfahrens auch mit einem thermischen Prüfsignal belastet werden, wobei ebenfalls das elektrische Antwortsignal des Piezoaktors gemessen wird, um den Piezoaktor zu prüfen. Bei dem thermischen Prüfsignal kann es sich beispielsweise um eine gezielte Erwärmung des Piezoaktors handeln, wobei die Erwärmung aufgrund des pyroelektrischen Effekts zu einem entsprechenden elektrischen Antwortsignal führt. Es ist jedoch grundsätzlich auch möglich, dass das thermische Prüfsignal aus einer Abkühlung des Piezoaktors besteht, um ein entsprechendes elektrisches Antwortsignal zu erzeugen.

Die Erfindung ist jedoch nicht auf die Prüfung von Piezoaktoren beschränkt, sondern erlaubt allgemein auch die Prüfung anderer Typen elektromechanischer Wandler, wobei mit dem erfindungsgemäßen Prüfverfahren insbesondere elektromechanische Aktoren geprüft werden können, die in Abhängigkeit von ihrer elektrischen Ansteuerung eine mechanische Stellbewegung erzeugen. Es ist jedoch im Rahmen der Erfindung theoretisch auch möglich, das Prüfverfahren bzw. die entsprechende Prüfeinrichtung zur Prüfung von elektromechanischen Wandlern einzusetzen, die zur Messung mechanischer Steuergrößen dienen und ein entsprechendes elektrisches Messsignal zu erzeugen, wobei diesbezüglich beispielsweise Drucksensoren zu erwähnen sind.

Aus dem Antwortsignal des elektromechanischen Wandlers wird vorzugsweise die Polungsrichtung des elektromechanischen Wandlers ermittelt, jedoch können im Rahmen des erfindungsgemäßen Prüfverfahrens bzw. der dazugehörigen Prüfeinrichtung auch andere qualitative oder quantitative Größen des Wandlers ermittelt werden.

Zur Bestimmung der Polungsrichtung des elektromechanischen Wandlers wird vorzugsweise zunächst die Polarität des von dem Wandler bei der mechanischen Belastung abgegebenen elektrischen Antwortsignals ermittelt, woraufhin die Polungsrichtung dann aus der ermittelten Polarität des Antwortsignals abgeleitet wird.

Die mechanische Belastung des elektromechanischen Wandlers mit dem mechanischen Prüfsignal kann beispielsweise hydraulisch oder pneumatisch erfolgen, jedoch ist die Erfindung nicht auf diese Arten einer mechanischen Belastung beschränkt.

Es wurde bereits eingangs erwähnt, dass die Prüfung des elektromechanischen Wandlers vorzugsweise im eingebauten Zustand erfolgt, während der Wandler in ein anderes Bauteil, wie beispielsweise einen Injektor, eingebaut ist. Dies bietet den Vorteil, dass zur Prüfung des elektromechanischen Wandlers keine vorherige Demontage erforderlich ist.

Injektoren für Einspritzanlagen mit einem eingebauten elektromechanischen Wandler weisen in der Regel eine Leckageleitung und eine Kraftstoffleitung auf, wobei diese Leitungen zur mechanischen Belastung des Wandlers mit dem mechanischen Prüfsignal verwendet werden können, indem ein Fluid mit einem vorgegebenen Druck in die Kraftstoff- bzw. Leckageleitung eingeleitet wird, was zu einer entsprechenden mechanischen Belastung des Aktors führt. Bei dem in die Leckage- bzw. Kraftstoffleitung eingeleiteten Fluid kann es sich beispielsweise um Luft oder Kraftstoff handeln, jedoch ist die Erfindung nicht auf derartige Typen von Fluiden beschränkt, sondern theoretisch auch mit anderen Fluiden zur mechanischen Belastung des Wandlers realisierbar.

Der Leckage- bzw. Kraftstoffanschluss des Aktors ist deshalb bei der erfindungsgemäßen Prüfeinrichtung vorzugsweise mit einer Druckquelle verbunden, welche das Fluid mit einem vorgegebenen Druck zuführt, um den elektromechanischen Wandler mechanisch zu belasten.

Ferner ist zu erwähnen, dass die Erfindung nicht auf das vorstehend hauptsächlich beschriebene Prüfverfahren beschränkt ist, sondern auch eine entsprechende Prüfeinrichtung umfasst.

Andere vorteilhafte Weiterbildungen der Erfindung sind in den Unteransprüchen gekennzeichnet oder werden nachstehend zusammen mit der Beschreibung des bevorzugten Ausführungsbeispiels der Erfindung anhand der Figuren näher erläutert. Es zeigen:
- Figur 1: das erfindungsgemäße Prüfverfahren in Form eines Flussdiagramms sowie
- Figur 2: eine schematische Darstellung der erfindungsgemäßen Prüfeinrichtung.

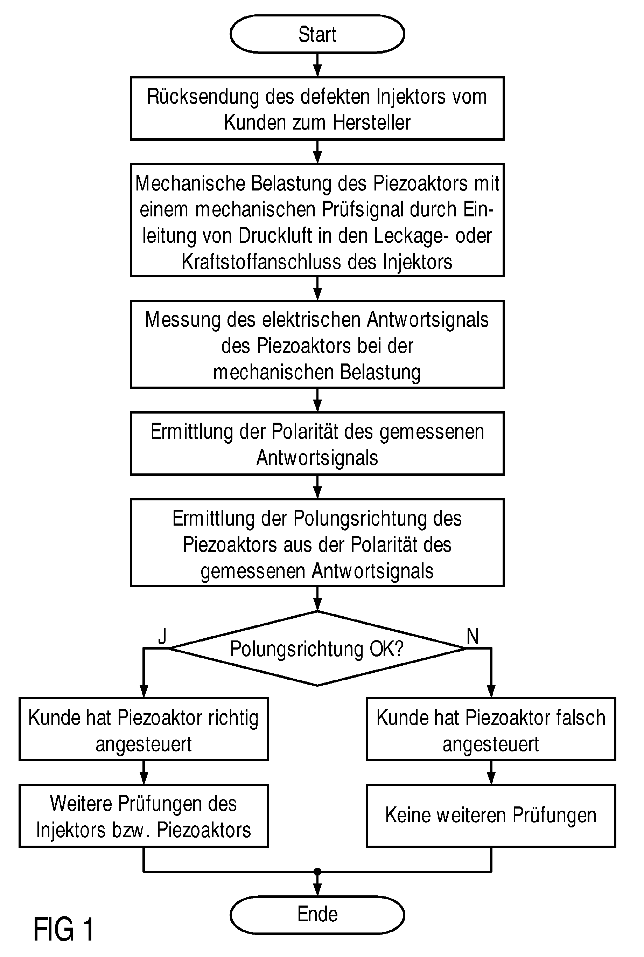

Bei dem in Figur 1 in Form eines Flussdiagramms dargestellten erfindungsgemäßen Prüfverfahren wird ein Injektor mit einem eingebauten Piezoaktor untersucht, der von einem Kunden (z.B. einem Autohersteller) zum Hersteller als Rückläufer zurückgesandt wird, weil der Injektor beim Kunden nicht ordnungsgemäß funktioniert.

Beim Hersteller wird der vermeintlich defekte Injektor dann dem erfindungsgemäßen Prüfverfahren unterzogen, wobei der Piezoaktor mit einem mechanischen Prüfsignal mechanisch belastet wird. Hierzu wird Druckluft in den Leckage- oder Kraftstoffanschluss des Injektors eingeleitet, wobei die Druckluft auf die Wirkfläche des Piezoaktors wirkt und diesen dadurch mechanisch belastet.

Aufgrund des piezoelektrischen Effektes des Piezoaktors entsteht durch die mechanische Belastung eine entsprechende elektrische Spannung, die an dem Piezoaktor als Antwortsignal abgegriffen wird, wobei das Antwortsignal die mechanische Belastung wiederspiegelt.

In einem weiteren Schritt wird dann die Polarität des gemessenen elektrischen Antwortsignals ermittelt, wobei aus der Polarität des gemessenen Antwortsignals die Polungsrichtung des Piezoaktors ermittelt werden kann.

Anschließend wird dann geprüft, ob die ermittelte Polungsrichtung des Piezoaktors der herstellerseitig vorgegebenen Polungsrichtung entspricht. Falls dies der Fall ist, so kann daraus geschlossen werden, dass der Kunde den Piezoaktor richtig angesteuert hat, so dass die Fehlfunktion des Injektors auf andere Ursachen zurückzuführen ist, die dann im Rahmen weiterer Prüfungen des Injektors bzw. des Piezoaktors ermittelt werden.

Falls die im Rahmen des erfindungsgemäßen Prüfverfahrens ermittelte Polungsrichtung des Piezoaktors dagegen nicht mit der herstellerseitig vorgegebenen Polungsrichtung übereinstimmt, so bedeutet dies, dass der Kunde den Piezoaktor falsch (d.h. nicht entsprechend der herstellerseitig vorgegebenen Polungsrichtung) angesteuert hat, was zu einer Umpolung geführt hat.

In diesem Fall werden keine weiteren Prüfungen des vermeintlichen defekten Injektors durchgeführt, da die Fehlfunktion des Injektors durch die fehlerhafte Ansteuerung beim Kunden verursacht wurde.

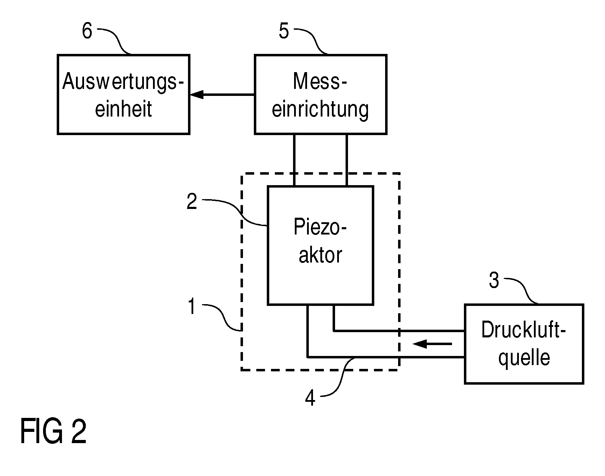

Figur 2 zeigt eine schematische Darstellung einer entsprechenden erfindungsgemäßen Prüfeinrichtung zur Prüfung eines Injektors 1 mit einem eingebauten Piezoaktor 2 für eine Einspritzanlage einer Brennkraftmaschine.

Zur mechanischen Belastung des Piezoaktors 2 weist die Prüfeinrichtung eine Druckluftquelle 3 auf, die mit einer Leckage- oder Kraftstoffleitung 4 des Injektors 1 verbunden ist, um die Wirkfläche des Piezoaktors 2 mit Druckluft zu beaufschlagen und dadurch mechanisch zu belasten.

Die elektrischen Anschlüsse des Piezoaktors 2 sind mit einer Messeinrichtung 5 verbunden, welche ein elektrisches Antwortsignal des Piezoaktors 2 misst, das durch die mechanische Belastung durch die Druckluftquelle 3 verursacht wird.

Ausgangsseitig ist die Messeinrichtung 5 mit einer Auswertungseinheit 6 verbunden, die das von der Messeinrichtung 5 gemessene Antwortsignal des Piezoaktors 2 auswertet und insbesondere die Polarität des Antwortsignals ermittelt, um daraus die Polungsrichtung des Piezoaktors 2 abzuleiten.

Die Erfindung ist nicht auf die vorstehend beschriebenen bevorzugten Ausführungsbeispiele beschränkt. Vielmehr ist eine Vielzahl von Varianten und Abwandlungen möglich, die ebenfalls von dem Erfindungsgedanken Gebrauch machen und deshalb in den Schutzbereich fallen.

## Patentansprüche

1. Prüfverfahren für einen elektromechanischen Wandler (2), insbesondere zur Prüfung der Polungsrichtung eines Piezoaktors in einem Injektor (1) für eine Einspritzanlage,
**gekennzeichnet durch**
folgende Schritte:
- Mechanische oder thermische Belastung des Wandlers (2) mit einem mechanischen oder thermischen Prüfsignal,
- Erfassung eines **durch** die Belastung erzeugten elektrischen Antwortsignals des Wandlers (2),
- Auswertung des Antwortsignals des Wandlers (2) zur Prüfung des in das Bauteil (1) eingebauten Wandlers (2).

2. Prüfverfahren nach Anspruch 1,
**dadurch gekennzeichnet,**
**dass** aus dem Antwortsignal des Wandlers (2) die Polungsrichtung des Wandlers (2) ermittelt wird.

3. Prüfverfahren nach Anspruch 2,
**dadurch gekennzeichnet,**
**dass** die Polarität des Antwortsignals ermittelt und aus der Polarität des Antwortsignals die Polungsrichtung des Wandlers (2) bestimmt wird.

4. Prüfverfahren nach einem der vorhergehenden Ansprüche,
**dadurch gekennzeichnet,**
**dass** die mechanische Belastung des Wandlers (2) mit dem Prüfsignal hydraulisch oder pneumatisch erfolgt.

5. Prüfverfahren nach Anspruch 4,
**dadurch gekennzeichnet,**
**dass** der Wandler (2) in ein Bauteil (1) eingebaut ist und im eingebauten Zustand geprüft wird.

6. Prüfverfahren nach einem der vorhergehenden Ansprüche,
**dadurch gekennzeichnet,**
**dass** der Wandler (2) ein elektromechanischer Aktor ist.

7. Prüfverfahren nach Anspruch 6,
**dadurch gekennzeichnet,**
**dass** der Aktor ein Piezoaktor (2) ist, der in einen Injektor (1) für eine Einspritzanlage einer Brennkraftmaschine eingebaut ist.

8. Prüfverfahren nach Anspruch 7,
**dadurch gekennzeichnet,**
**dass** der Injektor (1) einen Leckageanschluss und/oder einen Kraftstoffanschluss (4) aufweist, wobei zur mechanischen Belastung des Wandlers (2) ein Fluid in den Leckageanschluss und/oder in den Kraftstoffanschluss (4) eingeleitet wird.

9. Prüfverfahren nach Anspruch 8,
**dadurch gekennzeichnet,**
**dass** das zur mechanischen Belastung des Wandlers (2) eingeleitete Fluid Luft oder Kraftstoff ist.

10. Prüfverfahren nach einem der vorhergehenden Ansprüche,
**dadurch gekennzeichnet,**
**dass** der Wandler (2) bei der mechanischen Belastung mit dem Prüfsignal und bei der Messung des Antwortsignals elektrisch nicht angesteuert wird.

11. Prüfeinrichtung zur Prüfung eines elektromechanischen Wandler (2), insbesondere zur Prüfung eines Injektors (1) mit einem eingebauten Piezoaktor (2),
**dadurch gekennzeichnet**,
- einen Belastungsgeber (3) zur mechanischen Belastung des Wandlers (2) mit einem vorgegebenen mechanischen Prüfsignal,
- eine mit dem Wandler (2) verbundenen Messeinrichtung (5) zur Messung eines von der mechanischen Belastung erzeugten elektrischen Antwortsignals des Wandlers (2),
- eine mit der Messeinrichtung (5) verbundenen Auswertungseinheit (6) zur Auswertung des gemessenen Antwortsignals.

12. Prüfeinrichtung nach Anspruch 11,
**dadurch gekennzeichnet,**
**dass** die Auswertungseinheit (6) die Polarität des Antwortsignals ermittelt.

13. Prüfeinrichtung nach einem der Ansprüche 11 oder 12,
**dadurch gekennzeichnet,**
**dass** der Belastungsgeber (3) eine pneumatische oder hydraulische Druckquelle (3) aufweist, die mit dem Wandler (2) verbunden ist, um den Wandler (2) pneumatisch oder hydraulisch mit einem Fluid zu belasten.

14. Prüfeinrichtung nach einem der Ansprüche 11 bis 13,
**dadurch gekennzeichnet,**
**dass** das Fluid zur mechanischen Belastung des Wandlers (2) Luft oder Kraftstoff ist.

15. Prüfeinrichtung nach einem der vorhergehenden Ansprüche,
**dadurch gekennzeichnet,**
**dass** der Wandler (2) ein elektromechanischer Aktor ist.

16. Prüfeinrichtung nach Anspruch 15,
**dadurch gekennzeichnet,**
**dass** der Aktor ein Piezoaktor (2) ist, der in einen Injektor (1) für eine Einspritzanlage einer Brennkraftmaschine eingebaut ist.

17. Prüfeinrichtung nach Anspruch 13 und Anspruch 16,
**dadurch gekennzeichnet,**
**dass** der Injektor (1) einen Leckageanschluss und/oder einen Kraftstoffanschluss (4) aufweist, wobei die Druckquelle (3) mit dem Leckageanschluss und/oder mit dem Kraftstoffanschluss (4) des Injektors (1) verbunden ist, um den Piezoaktor (2) mechanisch zu belasten.

18. Prüfeinrichtung nach einem der Ansprüche 11 bis 17,
**dadurch gekennzeichnet,**
**dass** der Wandler (2) in ein Bauteil (1) eingebaut ist und im eingebauten Zustand prüfbar ist.
